# EUROPEAN PATENT SPECIFICATION

(11) **EP 3 948 673 B1**
(45) Date of publication and mention of the grant of the patent: **10.12.2025**
(21) Application number: 19714607.9
(22) Date of filing: 28.03.2019
(51) Int. Cl.: G06N 3/045, G06N 3/048, G06N 3/08, G06N 3/10, G06N 3/063, G06N 5/01

(54) **INTERMEDIATE NETWORK NODE AND METHOD PERFORMED THEREIN FOR HANDLING DATA OF COMMUNICATION NETWORKS**
ZWISCHENNETZWERKKNOTEN UND VERFAHREN ZUR HANDHABUNG VON DATEN VON KOMMUNIKATIONSNETZEN
NOEUD DE RÉSEAU INTERMÉDIAIRE ET PROCÉDÉ MIS EN OEUVRE DANS CE DERNIER POUR GÉRER DES DONNÉES DE RÉSEAUX DE COMMUNICATION

(43) Date of publication of application: 09.02.2022
(73) Proprietor: Telefonaktiebolaget LM Ericsson (publ), 164 83 Stockholm (SE)
(72) Inventor: KARAPANTELAKIS, Athanasios, 118 29 Stockholm (SE); ELEFTHERIADIS, Lackis, 818 32 Gävle (SE); BERGKVIST, Adam, 976 36 Luleå (SE); FERSMAN, Elena, 11123 Stockholm (SE); VANDIKAS, Konstantinos, 169 73 Solna (SE); ANDERSSON, Markus, 961 43 Boden (SE)
(74) Representative: Zacco Sweden AB
(86) International application number: PCT/EP2019/057846
(87) International publication number: WO 2020/192922

(56) References cited:
- S. TEERAPITTAYANON ET AL: "Distributed deep neural networks over the cloud, the edge and end devices", PROCEEDINGS OF THE 37TH INTERNATIONAL CONFERENCE ON DISTRIBUTED COMPUTING SYSTEMS (ICDCS'17), 5 June 2017 (2017-06-05), pages 328 - 339, XP033122945, DOI: 10.1109/ICDCS.2017.226
- E. LI ET AL: "Edge intelligence: on-demand deep learning model co-inference with device-edge synergy", ARXIV.ORG, CORNELL UNIVERSITY LIBRARY, 201 OLIN LIBRARY CORNELL UNIVERSITY ITHACA, NY 14853, 27 December 2018 (2018-12-27), XP081076383
- Y. HUANG ET AL: "When deep learning meets edge computing", PROCEEDINGS OF THE 25TH INTERNATIONAL CONFERENCE ON NETWORK PROTOCOLS (ICNP'17), 10 October 2017 (2017-10-10), XP033262232, DOI: 10.1109/ICNP.2017.8117585
- S. LEROUX ET AL: "The cascading neural network: building the Internet of smart things", KNOWLEDGE AND INFORMATION SYSTEMS, SPRINGER VERLAG,LONDON, GB, vol. 52, no. 3, 16 February 2017 (2017-02-16), pages 791 - 814, XP036289391, DOI: 10.1007/S10115-017-1029-1

## Description

### TECHNICAL FIELD

Embodiments herein relate to an intermediate network node and method performed therein for communication networks. Furthermore, a computer program product and a computer readable storage medium are also provided herein. In particular, embodiments herein relate to handling operations in a communication network.

### BACKGROUND

In a typical communication network, wireless devices, also known as wireless communication devices, mobile stations, stations (STA) and/or user equipments (UE), communicate via e.g. access points to servers or to one another. To understand environment such as images, sounds etc. one may use different ways to detect certain event, objects or similar. A way of learning is using machine learning (ML) algorithms to improve accuracy.

Computational graph models such as ML models are currently used in different applications and are based on different technologies. A computational graph model is a directed graph model where nodes correspond to operations or variables. Variables can feed their value into operations, and operations can feed their output into other operations. This way, every node in the graph model defines a function of the variables. Training of these computational graph models is typically an offline process, meaning that it usually happens in datacenters and takes several minutes to hours and days, depending on the underlying technology, the capabilities of the infrastructure used for training and the complexity of the computational graph model, e.g. amount of input data, parameters, etc. On the other hand, execution of these computational graph models is done anywhere from an edge of the communication network also called network edge, e.g. in devices, gateways or radio access infrastructure, to centralized clouds e.g. data centers.

In many cases, execution time is critical, i.e. time to obtain an output from the computational graph model, in particular for real-time applications, requiring low-latency feedback loops. A typical scenario is mobile devices in a wireless communication network requesting a decision from a centralized ML model execution environment, e.g. small devices that make use of object detection or augmented reality but have limited resources, e.g. glasses or other wearables, small robots like drones, etc.

There are some solutions already proposed including placing computing nodes executing ML models closer to the network edge, i.e. closer to the nodes requesting ML executions. Thus, one may place capable computing nodes closer to an entity requesting execution of an ML model in order to reduce the time required to communicate input data to a computational graph model and get a response. However, placing these computing nodes close to the edge is an expensive task, especially when considering distributed radio access technologies of wireless communication networks, having thousands of radio base stations covering wide urban and rural areas.

Another solution is to use proxy servers at the edge instead of computing nodes in order to memorize responses from most frequent calls made to a ML model. Thus, the proxy node merely responds back to a requesting node to requests that are exactly as previous requests already executed in the core network node. Thus, one may use a local cache server, or a proxy server, which is placed as close as possible to the edge and the local cache server memorizes the responses for most frequent requests that are being made to a machine learning model. In most cases machine learning models are delivered as restful services therefore any http-based cache/proxy server would suffice for this task. However, this solution is also not good enough since it will be limited to:
- very specific request/response patterns
- to the amount of available memory of the cache server and
- to the cache eviction policy scheme.

By default, new requests that were never seen before by the cache server will be sent back to the original machine learning model as hosted in the cloud.

The publication "Distributed deep neural networks over the cloud, the edge and end devices" by Teerapittayanon et. al (PROCEEDINGS OF THE 37TH INTERNATIONAL CONFERENCE ON DISTRIBUTED COMPUTING SYSTEMS (ICDCS'17), 5 June 2017 (2017-06-05), pages 328-339, DOI: 10.1109/ICDCS.2017.226) discloses a novel DDNN framework and its implementation that maps sections of a DNN onto a distributed computing hierarchy.

### SUMMARY

The invention is defined by the independent claims. Furthermore, the embodiments of the invention are those defined by the claims. Moreover, examples and embodiments, which are not covered by the claims, are presented not as embodiments of the invention, but as background art or examples useful for understanding the invention. An object of embodiments herein is to provide a mechanism for improving operations of a wireless communication network in an efficient manner.

According to an aspect the object is achieved by providing an intermediate network node configured to operate in a communication network, wherein the communication network comprises a requesting node such as a wireless device or similar, and an executing network node such as a cloud server, comprising a computational graph model. The intermediate network node is configured with an imitation model, wherein the imitation model is a limited version of the computational graph model, and wherein the imitation model is a model requiring less computational resources to converge when compared to the computational graph model, wherein the intermediate network node is configured to build the imitation model based on received one or more input parameters from the requesting node, the intermediate network node further being configured to: intercept a request from the requesting node, the request being for execution of the computational graph model; run the imitation model using input from the requesting node and check confidence of an output; when the confidence is higher than a threshold, transmit a response to the requesting node; and when the confidence is lower than a threshold, relay the request to the executing network node.

According to another aspect the object is achieved by providing a method performed by an intermediate network node for operating in a communication network, wherein the communication network comprises a requesting node and an executing network node comprising a computational graph model. The intermediate network node obtains an imitation model, wherein the imitation model is a limited version of the computational graph model, and wherein the imitation model is a model requiring less computational resources to converge when compared to the computational graph model, and wherein the imitation model is built based on received one or more input parameters from the requesting node. The method comprises: intercepting a request from the requesting node, the request being for execution of the computational graph model; running the imitation model using input from the requesting node and checking confidence of an output; when the confidence is higher than a threshold, transmitting a response to the requesting node; and when the confidence is lower than a threshold, relaying the request to the executing network node.

It is furthermore provided herein a computer program product comprising instructions, which, when executed on at least one processor, cause the at least one processor to carry out any of the methods above, as performed by the intermediate network node. It is additionally provided herein a computer-readable storage medium, having stored thereon a computer program product comprising instructions which, when executed on at least one processor, cause the at least one processor to carry out the method according to any of the methods above, as performed by the intermediate network node.

Embodiments herein provide usage of imitation models, closer to the edge of the communication network. One or more imitation models may be configured between the network path of the requesting node and the executing network node, i.e. the network node executing the computational graph model in full, and the one or more imitation models may require less computational resources than the computational graph model based on deep learning. The intermediate network node executing the imitation model provides one or more responses to well-known computations of input on a request, without the request having to traverse a long network path to a centralized datacenter i.e. the executing network node. Thus, embodiments herein enable that operations of the wireless communication network is improved in an efficient manner.

### BRIEF DESCRIPTION OF THE DRAWINGS

Embodiments will now be described in more detail in relation to the enclosed drawings, in which:
Fig. 1 is a schematic overview depicting a communication network according to embodiments herein;
Fig. 2 is a combined flowchart and signaling scheme according to embodiments herein;
Fig. 3 is a schematic overview depicting a communication network according to embodiments herein;
Fig. 4 is a combined flowchart and signaling scheme according to embodiments herein;
Fig. 5 is a schematic overview depicting a way of building the imitation model according to embodiments herein;
Fig. 6 is a flowchart depicting a method performed by an intermediate network node according to embodiments herein;
Fig. 7 is a schematic overview depicting radio units arranged in different scenarios; and
Fig. 8 is a block diagram depicting embodiments of an intermediate network node according to embodiments herein.

### DETAILED DESCRIPTION

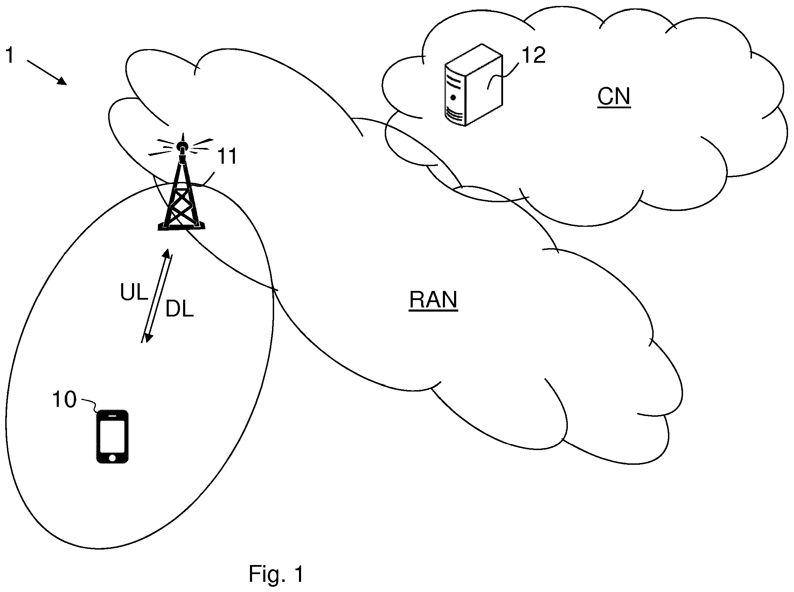

Embodiments herein relate to communication networks in general. **Fig. 1** is a schematic overview depicting **a communication network 1.** The communication network 1 may be any kind of communication network such as a wired communication network or a wireless communication network comprising e.g. a radio access network (RAN) and a core network (CN). The communication network may serve one or more **requesting nodes 10** such as UEs, remote radio units, radio base stations, or similar. Embodiments herein relate to **an intermediate network node 11** for handling operations, such as providing responses, in the communication network 1. The intermediate network node may be a baseband unit, a radio network node such as a base station or an access node e.g. wireless local area network node, a user equipment, a gateway node, core network node, or another network node. The requesting nodes 10 are communicating with the network node by transmitting data to the network nodes in uplink (UL) and receieving data in downlink (DL). The intermediate network node 11 is configured to operate in the communication network e.g. between the one or more requesting nodes and **an executing network node 12.** The executing network node 12 may be a central cloud node, such as a centralized application server, a core network node, or similar comprising a computational graph model, e.g. a deep learning model such as a ML model. According to embodiments herein the intermediate network node 11 is configured with an imitation model, wherein the imitation model is a limited version of the computational graph model, and wherein the imitation model is a model requiring less computational resources to converge when compared to the computational graph model. The imitation model may be received as a part of the computational graph model from the executing network node 12 and is built or created at the intermediate network node itself. The methods according to embodiments herein are performed by the intermediate network node 11. As an alternative, a Distributed Node (DN) and functionality, e.g. comprised in a cloud may be used for performing or partly performing the methods.

Embodiments herein may cover a wide range of computational graph models such as ML models, including those trained using deep learning, e.g. artificial neural networks such as Convolutional Neural Networks, and may reduce execution latency without expensive hardware equipment at the network edge. Since there is no need for hardware equipment capable for executing complex ML models on requesting node such as wearables or other devices, the cost of these devices may be reduced.

Thus, the communication network 1 may be any packet-switched packet network and/or may be a communication network having wireless access to connected requesting nodes at the edge of the communication network 1, where the requesting node requests computational graph model execution from the executing network node 12 being a more centralized node. The nodes mentioned herein are
- The requesting node 10 or requesting point (RP) being a node requesting a model execution. This requesting node 10 may be a device that provides an input to the model. This input can consist of one or more values, e.g. numbers, alphanumerics and/or more complex data structures such as lists, arrays, etc. The requesting node 10 may e.g. be a mobile device, which in best interest of saving battery and due to lack of computational resources requests from another network node execution of a computational graph model.
- The intermediate network node 11, which comprises the imitation model also called "imitator model". The intermediate network node 11 may intercept requests from the requesting node 10 to the executing network node 12 and may record the input. If the input is something that the intermediate network node 11 encountered before, then the intermediate network node 11 may immediately respond with the output back to the requesting node 10. Otherwise, the intermediate network node 11 may relay the request to the executing network node 12 and captures the output of executing network node 12 as a response. The intermediate network node 11 may e.g. build a simple model trained from input data and output information pairs in the process.
- The executing network node 12, which executes the computational graph model, also called parent model, and produces an output. The output is sent to the requesting node 10 that originated the "model execution" request.

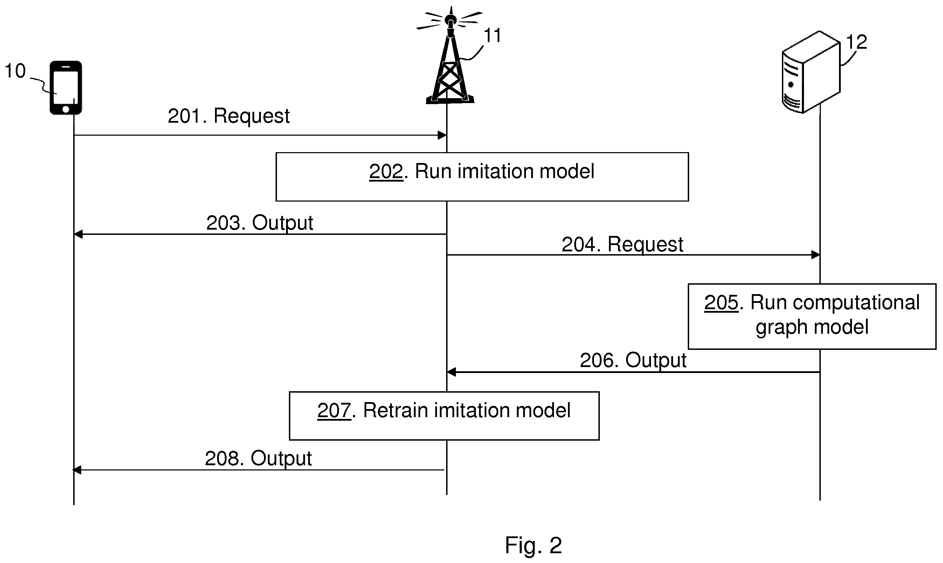

**Fig. 2** shows the sequence flow, triggered from a model execution request from the requesting node.

**Action 201.** The requesting node 10 transmits a request for execution of a computational graph model such as a ML model. E.g. the requesting node 10 may transmit a model execution request.

**Action 202.** The intermediate network node 11 intercepts the request and checks confidence of output. I.e. the intermediate network node 11 runs the imitation model using the input from the requesting node 10 and checks confidence of the output, i.e. how well the model performs by evaluating how close is the output to the one expected. Assessment of performance whether a model is well-performing or not, may be done by one or more metrics on the output of the model. Low confidence equals low performance and high confidence equals high performance.

**Action 203.** The intermediate network node 11 if high confidence of output then transmits a response such as the output of the imitation model back to the requesting node 10.

**Action 204.** The intermediate network node 11 if low confidence of output, relays the request to the executing network node 12. High and low confidence are determined by comparing to a threshold of confidence.

**Action 205.** The executing network node 12 may then receive the request and run the computational graph model such as a neural network or similar.

**Action 206.** The executing network node 12 may further send an output from the computational graph model to the requesting node 10 via the intermediate network node 11.

**Action 207.** The intermediate network node 11 may intercept the response i.e. the output and may retrain the imitation model with the received output.

**Action 208.** The intermediate network node 11 may further transmit the output to the requesting node 10.

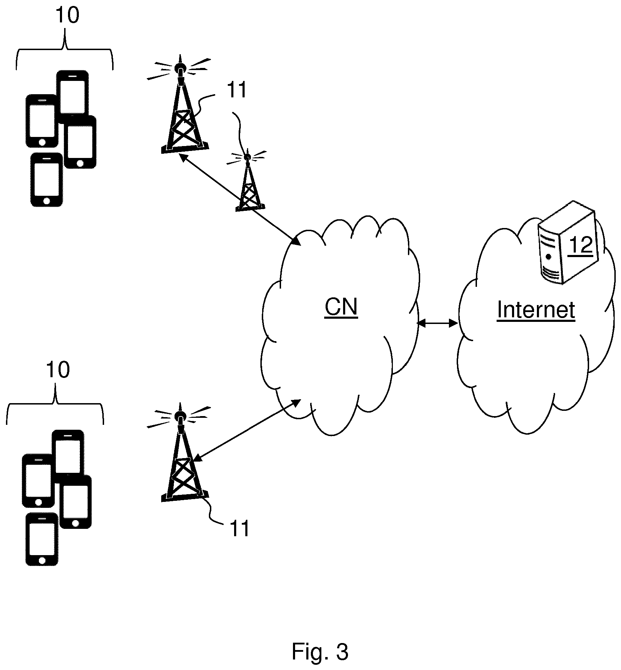

**Fig. 3** shows a non-limiting implementation in a 3GPP context. In this implementation the requesting nodes are assumed as UEs, the intermediate network node 11 is assumed as a RAN node, e.g. baseband node, and the executing network node 12 is a public cloud provider on the internet, for example a model can be executed on a platform such as Amazon AWS, Google compute cloud, Microsoft Azure, etc. This is just one of the possibilities for this idea being implemented in 3GPP network. The executing network node 12 for example could be in the operator (core network) private cloud.

It should be noted that depending on a computational capability of the intermediate network node 11 and the complexity of the computational graph model running on the executing network node 12, the intermediate network node 11 may build a simple or a more complex imitation model. The simplest form of this imitation model is a ruleset, e.g. using simple IF <input> THEN <output> rules. A more complex form could have input of the imitation model represented as an input vector, a so-called vector space model, and then using a similarity measure to match the input rules to an existing <input, output> pair. If similarity measure is above a threshold, then the output is returned. An even more complex method is to train a simple neural network using only a subgraph of the executing network node's computational graph model. If the prediction interval returned by the neural network for the given input is more than a threshold, then the output is returned directly, otherwise the neural net is retrained from an aggregate of legacy output data and output data supplied by the executing network node 12, upon relaying of model execution request from the intermediate network node 11.

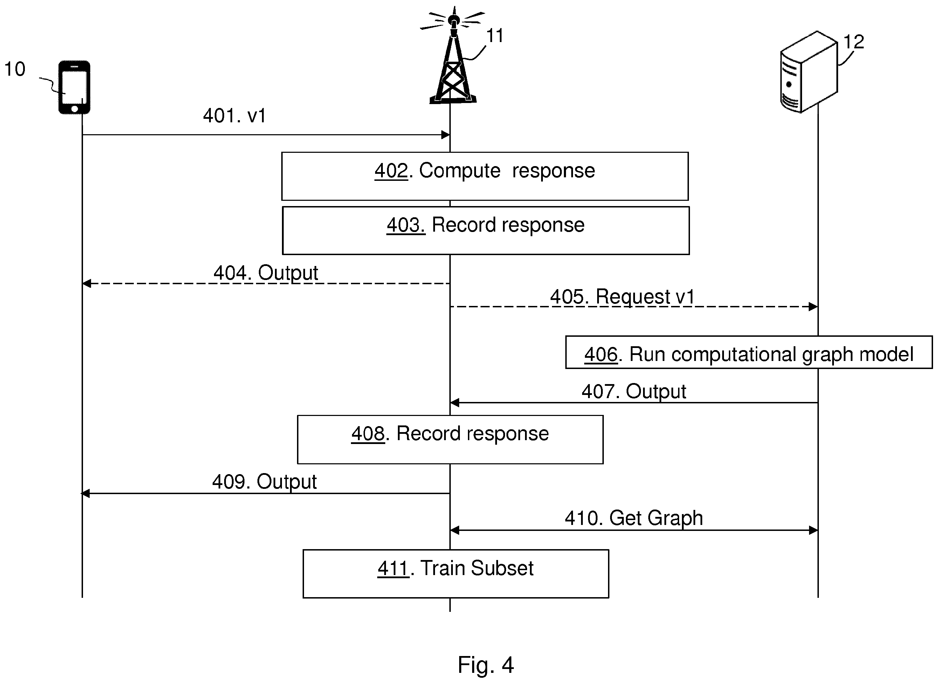

In **Fig. 4** it is shown how the imitation model may be obtained e.g. built. Initially the computational graph model e.g. the full machine learning model is comprised in the executing network node 12 or cloud. By machine learning model here we refer to any computational graph model such as a neural network (feed forward or recurrent) but also a decision tree. Intermediate network nodes 11 between the executing network node 12 and the requesting nodes 10 are initially empty and have no memory of any requests and/or responses. Even though neural networks are different than decision trees in terms of inference and/or execution, for the purposes of simplicity we assume that a "compute" function is capable of dealing with these differences.

**Action 401.** The requesting node 10 may transmit a vector v1 to the executing network node 12.

**Action 402.** The intermediate network node 11 intercepts the request and may compute a response using the vector.

**Action 403.** The intermediate network node 11 may further record the response. A record function may take into consideration available memory in the requesting node 10 but also an eviction policy such as Least Recently Used (LRU).

**Action 404.** The intermediate network node 11 may in some embodiments indicated by the dashed line transmit the response to the requesting node 10, e.g. when the confidence of the output is indicating that the output is close to the one expected.

**Action 405.** In case the intermediate network node 11 is not capable of computing the response, e.g. when the confidence is low, the intermediate network node 11 may in some embodiments, indicated by the dashed line, relay the request, i.e. the vector v1 to the executing network node 12.

**Action 406.** The executing network node 12 may then receive the request and run the computational graph model such as a neural network or similar.

**Action 407.** The executing network node 12 may further send an output from the computational graph model to the requesting node 10 via the intermediate network node 11.

**Action 408.** The intermediate network node 11 may intercept the response i.e. the output and may record the response.

**Action 409.** The intermediate network node 11 may further transmit the output to the requesting node 10.

A subgraph function produces a smaller version of the original computational graph model. A possible way to implement this would be by using an adjacency matrix to represent a neural network such as:

| | 0 | 1 | 2 | 3 |
|---|---|---|---|---|
| 0 | | 1 | | |
| 1 | 1 | 1 | 1 | |
| 2 | 1 | 1 | 1 | 1 |
| 3 | 1 | 1 | 1 | |
| 4 | | 1 | | |

A subgraph function i.e. the imitation model may be the following where we intentionally omit the last row and the last column.

| | 0 | 1 | 2 |
|---|---|---|---|
| 0 | | 1 | |
| 1 | 1 | 1 | 1 |
| 2 | 1 | 1 | 1 |
| 3 | | 1 | |

This particular subset is valid in cases where we can safely abuse the amount of input and output parameters. If this is not the case then a subset graph may be produced by omitting columns from different parts of the matrix except the first and the final column.

As soon as the intermediate network node 11 considers that it has collected enough data it initiates a training session if it has been idle for a certain period (meaning no incoming requests). To do that may the intermediate network node 11 first retrieve, **action 410,** the structure of the computational graph model from the executing network node 12 and intentionally pick a subset of it, **action 411.** Afterwards the intermediate network node 11 may repeat a training process, incrementally adding more parts of the original computational graph model's structure and checking if the accuracy of the training process is high enough. At the end of the training process the intermediate network node 11 may report the results back to the executing network node 12. The executing network node 12 may then use this information later on to identify if its computational graph model is still good enough or if it needs to be retired.

It should further be noted that several levels of imitation models may be used (the further away from the requesting node, the smarter or more complex imitation model). The imitation model may be able to notify the "parent", that is the executing network node or an intermediate network node of a higher rank that it's deviating from reality and requests an update. Embodiments herein may retire, e.g. forget, parts of the imitation model that have not been used for a while to prevent them from growing and becoming as big as the original computational graph model. Embodiments herein may pre-fetch information for the imitation model based on likelihood of the information being useful in the future. An addition of an "assignment function", to dynamically assign or reassign intermediate network nodes in a path between the requesting node 10 and the executing network node 12. This function may be triggered if a current intermediate network node performance is below a threshold and/or the current capacity/quality of links is also below a threshold. Intermediate network node performance may be measured as a time it takes for the imitation model in the intermediate network node 11 to converge. Capacity/quality of the link can be measured using standard metrics, such as latency, packet drops and jitter. Both metrics may be monitored over a pre-specified amount of time for degradation e.g. interval, which will subsequently trigger the new intermediate network node assignment. If a new node is assigned an intermediate network node role, the imitation model or models executed in node losing the intermediate network node role may be migrated to the new node with the intermediate network node role, in addition to the requesting node-initiated model execution requests currently processed.

One way to produce the imitation model may be from an upstream advanced computational graph model. The upstream advanced computational graph model may be an ensemble model where multiple models are used to produce an aggregated result at the executing network node 12. Internally, the individual models may have different weights with regard to how they affect the aggregated result. To derive an imitation model to be run at a specific network edge, one approach is to create a "subset ensemble" only containing most significant models. There can be a component that records how traffic from a specific part of the network utilizes the different models in the ensemble to determine which models that can be discarded to produce the imitation model. Like in an ensemble case, each "sub model" can be considered as an graph component of the computational graph model.

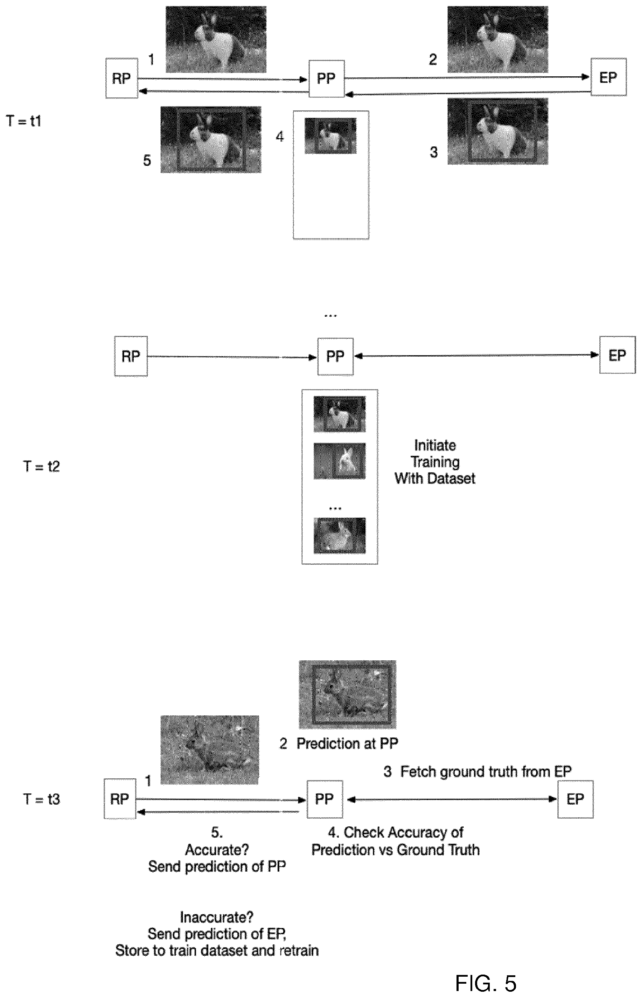

**Fig. 5** illustrates an object detection scenario but it should be noted that any type of classification may implement embodiments disclosed herein.

At t1, a model is pretrained with pretrained weights, e.g. from ImageNet, at the intermediate network node 11. A picture of a rabbit may be sent from the requesting node 10 for detection, intermediate network node 11 cannot figure out the rabbit picture, and sends a request to the executing network node 12, which has complete computational graph model and receives a confirmed rabbit back (3), forwards (5) result to the requesting node 10, while storing (4) rabbit in its own internal dataset.

At t2, the intermediate network node 11 has already built a good enough dataset, e.g. 1000 rabbits, to initiate training, e.g. using 10% of those for testing and 90% for training.

At t3, the intermediate network node 11 receives a new request after training (1). At this point, the intermediate network node 11 may also check whether it made a good prediction with input metrics, precision and/or recall can be used as metrics. If all check out, the intermediate network node 11 may use it's pretrained model to offer a response. If not, then it waits to gather a larger dataset. The check between the intermediate network node 11 and the executing network node 12 can be periodic, e.g. for every 100th request, and after some checks, the intermediate network node 11 no longer needs to check with the executing network node 12 as it has a good enough model.

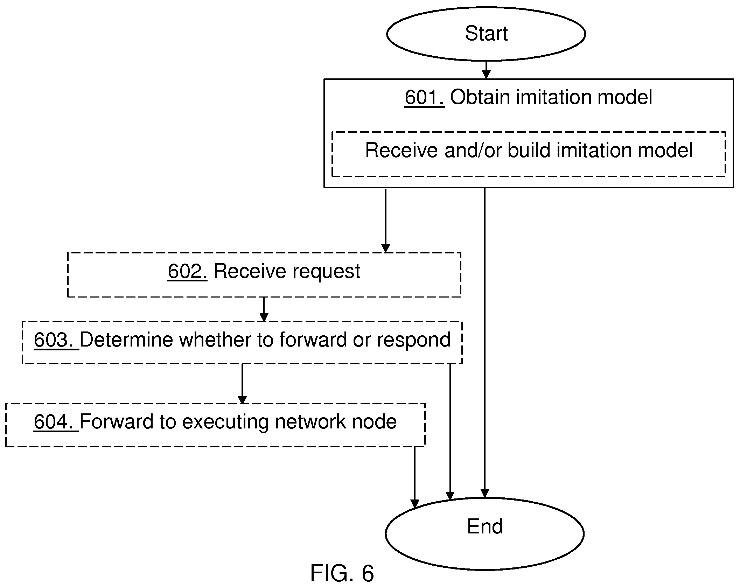

The method actions performed by the intermediate network node 11 for operating in the communication network 1 according to embodiments herein will now be described with reference to a flowchart depicted in **Fig. 6****.** The actions do not have to be taken in the order stated below, but may be taken in any suitable order. Actions performed in some embodiments are marked with dashed boxes. The communication network 1 comprises the requesting node 10 and the executing network node 12 comprising the computational graph model. The intermediate network node 11 may be configured to operate between the requesting node 10 and the executing network node 12.

**Action 601.** The intermediate network node 11 obtains the imitation model. The imitation model is a limited version of the computational graph model, and wherein the imitation model is a model requiring less computational resources to converge when compared to the computational graph model. the imitation model comprises one or more of following compared to the computational graph model: at least one input parameter less than the computational graph model; at least one output parameter less than the computational graph model; one or more functions of less computational complexity; and at least one less internal vertex or node of the computational graph model and/or at least one less edge of the computational graph model. Graphs are data structures that can be ingested by various algorithms, notably neural nets, learning to perform tasks such as classification, clustering and regression. Algorithms can "embed" each node of a graph into a real vector. The result will be vector representation of each node in the graph with some information preserved. The vector ma then be fed it to the neural network. The simplest definition of a graph is -a collection of items connected by edges. The items are often called nodes or points and the edges may be called vertices.

The intermediate network node 11 may e.g. receive the imitation model from the executing network node 12. E.g. the imitation model may be obtained from the computational graph model. Additionally or alternatively, the imitation model may be built based on received one or more input parameters from the requesting node 10 and/or one or more output parameters from the executing network node 12. It should be noted that the imitation model may be built based on input from one or more requesting nodes since the intermediate network node 11 may serve multiple requesting nodes. The imitation model may be built by removing one or more parts of the imitation model that have not been used within a set interval. E.g. remove input parameters or nodes of the model that has not been used within a time interval. The computational graph model may be a neural network and/or a decision tree. The computational graph model may further be an ensemble model wherein the executing network node 12 comprises a model comprising a number of imitation models built at different intermediate network nodes.

**Action 602.** The intermediate network node 11 may receive a request from the requesting node 10, wherein the request comprises one or more input parameters.

**Action 603.** The intermediate network node 11 may further determine whether to respond to the request or to forward the one or more parameters towards the executing network node 12 by comparing the one or more input parameters to one or more needed input parameters of the imitation model and/or based on one or more output parameters of the imitation model. Need input parameters meaning input parameters parameter needed to run the imitation model with e.g. a high confidence of the result.

**Action 604.** The intermediate network node 11 may forward the one or more parameters to a second intermediate node comprising a second imitation model being a version of the computational graph model requiring less computational resources to converge when compared to the computational graph model but more computational resources than the imitation model.

Embodiments herein achieve a low-latency response of model execution requests.

In an augmented reality example, an imitation model may be executed locally on a device, with other more capable models being executed remotely in the cloud. E.g. the imitation model may be enough to detect objects that the device has encountered before, reverting to the parent model, e.g. the computational graph model, only for objects that it has not seen before (e.g. when device changes environment).

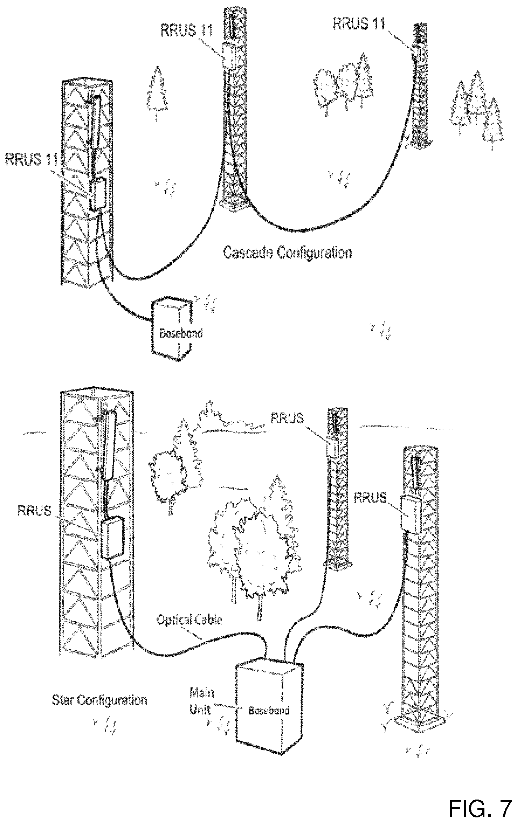

A more 5G network focused example has to do with power estimation and power allocation on the 5G radio units (e.g. remote radio units). These units are part of a radio base station and from an architecture perspective, they are situated between the antenna and the baseband processing unit as illustrated in Fig. 7. Fig. 7 shows a typical setup of a radio base station, comprising antennas, remote radio units and a cabinet housing the baseband among other components (e.g. power supply, fan control units, routers, etc.).

The main task of the radio unit is to convert analog signals received from the antenna to digital and vice versa, but it also has a power amplifier (PA) function - allocating and supplying power to antenna. The power allocated to the antenna is done from a control method inside the radio unit. Current power estimation and control method is done every transmission time interval (TTI) - every 1 ms.

It is currently based on the current data traffic received from and/or transmitted to the radio unit. It is possible to enhance this power control function using predictions that include UE-supplied reference signals, created to control the power transmitted on the radio unit, for example Channel State Information-Reference Signal (CSI-RS) and Reference Signal Received Power (RSRP). CSI-RS is used by the UE to estimate the channel and report channel quality information (CQI) to the base station, while RSRP denotes the power of the cell communication channel as measured by UE. In addition, more information such as radio site configuration information, power supply information and power reserve (in case of battery usage), historical traffic patterns, etc may be used.

In order to stay within the 1ms requirement, an imitation model may run within the radio unit, while a more powerful model can run on the baseband or even at the core network or on a public cloud provider, there can also be multiple layers of imitation models of the different radio units.

A use case that proves the feasibility and advantages of embodiments herein will now be discussed. Machine learning models used may be object detection models, and specifically models that use convolutional neural networks. Before discussing the use case, convolutional neural network theory is herein mentioned and what drives complexity in convolutional neural network models. It should be noted that training of the model is not discussed but only the execution of the model.

### Convolutional Neural Networks Introduction

A neural network is a computational structure inspired by biological neural networks which serve as cells of the human brain. A neuron is the basic unit of computation in these neural networks. Simply put, it is a function receiving input, transforming it and outputting it. A neural network comprises of many interconnected neurons, the output of one being input to another. A convolutional neural network (CNN) is a special type of neural network, which considers neurons arranged in multidimensional layers. For a user of this network (i.e. the requestor of a model execution), the intermediate layers are hidden, and only input layer and output layer are visible.

There are two basic operations in neural networks: first is feature learning and second is classification. The most computationally expensive operation is feature learning and is herein described.

From a data perspective, an input image can be represented as a matrix of values. Depending on the color model used, the value matrices can be of different dimensions. For example, if the Red Green Blue (RGB) color model is used, matrices are 3-dimensional, whereas if the Cyan, Magenta, Yellow and key (CMYK) color model is used, matrices are 4-dimensional. The input image may be RGB image and may have 32 pixels height and 32 pixels width, therefore the input image is represented a 32x32x3 matrix.

Initially, a sliding window (also called a receptive field) is applied to the image. A receptive field is a small area of the image which constitutes the focus of the object detection algorithm. This area slides across the image (e.g. by 1 pixel in what is known as stride). For every new receptive field, a series of filters are applied. Filters are multidimensional matrices which have the same depth as the image and are essentially what was described above as neurons. What happens in each step is the process of convolving the receptive field of the image with the values of the filter and writing the result to a new matrix known as activation map. This process involves a multiplication operation of the receptive field data with that of the filter and the application of a weight to this operation (dot product). A filter can help distinguish features such as lines, edges, curves etc., but also perform background extraction, etc. From an image processing perspective these operations could be described as blurring, sharpening, edge detection, etc. Many filters can be applied to an image, each filter creating a 1-dimensional activation map. At the end of the operation, there are multiple activation maps created, one for every filter. This set of activation maps is known as a convolutional layer - the combination of values from an input layer and the values of multiple filters. In this convolutional layer, further operations may be performed in order to increase accuracy of the model and reduce computational complexity. One of these operations is ReLU, which introduces non-linearity by turning negative results of the dot product into 0 (which basically makes sure that the activation map does not contain negative numbers). Pooling is another function that down-samples (i.e. "densifies") the activation map without losing valuable information. The reason for pooling is to reduce computational complexity in subsequent operations. The process repeats with the pooled activation maps being transformed into new activation maps of smaller size (but larger number). The number of convolutional layers as well as the number of filters depends on the use case, for example, size and variance of input data, number and complexity of different objects to be detected - also known as classes, etc. The deeper we go into this layer structure, the activation maps will represent more and more complex features, for example from simple parts of lines or semi-circles to complete lines or circles, to objects.

The second part of a convolutional neural network is classification. This is a process where a fully connected layer is attached to the network, also known as FC layer. This layer takes as input the pooled feature maps of the preceding layer and transforms them into a vector of N dimensions (N being the number of classes - or different objects to be detected). Each value of the vector represents a probability that an object exists in the image. For example, let's say that we want to detect 2 classes, a radio unit and an antenna on the tower. This would mean that we would convert all activation maps to a two-dimensional vector. For example, if result is [0, 0,8] and first dimension is radio unit and second an antenna, that means that there is 80% probability that an antenna exists in the image. Softmax is a function used typically for this purpose. The idea is that on the last layers, features of objects are extracted. For example, for a radio unit, high-level features in activation maps of the penultimate layer may identify parts of the radio unit, e.g. it's cooling system and a company log, and the weatherproofing, which if all taken into account indicate a strong possibility of the presence of a radio unit. Some more notes here is that there could be more than one fully connected layer. The key difference is that fully-connected layers are global, i.e. they operate in the complete image and may help in extracting relationships between the features. For example, if we want to see that there is a weatherproofing adaptor connected to a radio unit (both of which are detected in the first FC layer), then we add a new FC layer to do that. We end up in this case with a "RU with weatherproofing" object.

### Complexity Drivers in CNN execution

There are several factors affecting CNN execution, including the number of convolutions, but the matrix multiplications ("convolutions") when calculating the activation matrices are the ones that are the most computationally expensive and the ones taking the most time. Therefore, the number of convolutional layers and number, size of filters used for multiplication operations in every layer can be considered as the complexity drivers.

In our example, drones doing maintenance of validation/acceptance operations on radio towers are considered. Instead of a human engineer climbing the radio tower and checking the status of the equipment, a drone flies to the radio tower and performs automated inspection. Instead of having a qualified drone operator fly the drone to the tower, a field technician only needs to unpack the drone and trigger an automated surveillance procedure. The field technician can inspect the cabinet of the site, while the drone performs an automated surveillance of the tower-top equipment, thus reducing time of inspection and also not requiring piloting skills on behalf of the technician (technician can still abort the process and maintain line of sight with the drone, in order to abide to legal requirements). What is meant by surveillance may e.g. be automated assessment of cable bend radius, i.e. if cables are bent below a minimum angle or similar.

In order for the drone to perform surveillance it needs to know where to focus. Object detection of tower equipment is used in order to position the drone at the right height and angle, in order to perform the assessment -this would mean positioning the drone e.g. directly below the radio unit, antenna, or microwave link. In order to do this positioning, the drone sends an object detection request to a server executing an ML object detection model. The server responds with the detected objects, which the drone uses to plan its navigation. A 40 ms latency is acceptable in order for the drone to perform navigation, anything more than that and it may compromise the correctness of the position the drone needs to be in order to perform the assessment.

In previous work, some of the authors estimated that the propagation across two devices within the same LTE network (not taking under account internet propagation delay) is estimated to be between typically between 20-40 ms round trip, so having the object detection running on a third-party cloud, i.e. outside of operator's network, could become an issue. One approach would be to have a model with all classes (all objects) running somewhere centrally, e.g. in the operator's core network. However, this will result in a more computationally complex model. The reason behind this is that the training dataset and configuration used to train the model needs to account for variations in site configuration. For example, in order for the detector to identify an object (e.g. a particular radio unit model) in different types of lighting conditions and against different backgrounds, not only a larger training set needs to be used, but also more layers to increase precision. On the other hand, a smaller model (in terms of classes and layers) on the network edge (e.g. close to the base station), would be sufficient to identify the radio unit in question.

Thus, the imitation model such as a detection model may be run closer to the edge and have respectable accuracy and real-time performance with cheap commercial off the self (COTS) hardware, shortening control loops, whereas larger object detection models cannot. To be able to deal with the variance, such general models would need to have a much more complex CNN structure, which causes a drop in terms of performance and could therefore run as reference models somewhere in a centralized repository.

### Latency degradation

Latency is performance parameter that may be used where we aim at predicting if the latency of a cell is going to deteriorate, improve or remain the same in the next 24 hours. For this reason, we have trained a feed-forward neural network, e.g. Two Layer Perceptron, which uses an array of 2540 (KPIs) as input and produces 3 different outputs (has 3 neurons in it's final layer). The full Neural Network seating at the cloud looks like this :

| Layer (type) | Output Shape | Param # |
|---|---|---|
| dense_1 (Dense) | (None, 512) | 1300992 |
| batch_normalization_1 | (Batch (None, 512) | 2048 |
| dense_2 (Dense) | (None, 3) | 1539 |
| batch_normalization_2 | (Batch (None, 3) | 12 |
| activation_1 (Activation) | (None, 3) | 0 |

The second layer (also known as hidden layer) has 512 neurons. The accuracy of this model after trained for 100 epochs is 88%. Training of this model on a multi-core central processing unit (CPU) system takes 7 minutes. Inference takes 3.1 ms on the same machine.

Near the edge for the purposes of efficiency a subset of the computational graph model, i.e. the imitation model, is deployed which is good at identifying only two out of 3 cases - the case where latency remains stable and the case where it deteriorates. This choice is intentional since near the "edge‴ you really care mostly about the cases that may cause trouble in your cells.

The following model is a subset of the original ->

| Layer (type) | Output Shape | Param # |
|---|---|---|
| dense_1 (Dense) | (None, 256) | 650496 |
| batch_normalization_1 | (Batch (None, 256) | 1024 |
| dense_2 (Dense) | (None, 2) | 514 |
| batch_normalization_2 | (Batch (None, 2) | 8 |
| activation_1 (Activation) | (None, 2) | 0 |

This model has the same input (2540), a smaller hidden layer 256 and only 2 outputs. The accuracy of this model is 76%. However, in the same dataset if we label the cases that previously have been labelled as "latency is improving" to "latency remains stable" the accuracy becomes 87% therefore we are able to regain high enough accuracy on the edge. Different kind of devices can be considered as viable hosts for imitation models on the edge. One example would be the NVIDIA Jetson TX2. In this case training (for the entire dataset) takes 34 minutes (the Jetson has only 256 CUDA cores but it consumes 7.5W). Inference on the Jetson for the same model is 70 ms. Given that our prediction is designed to be valid for the next 24 hours, 70 ms as opposed to 3.1 ms is something that we can tolerate. Please mind that in these examples, network latency is not accounted for.

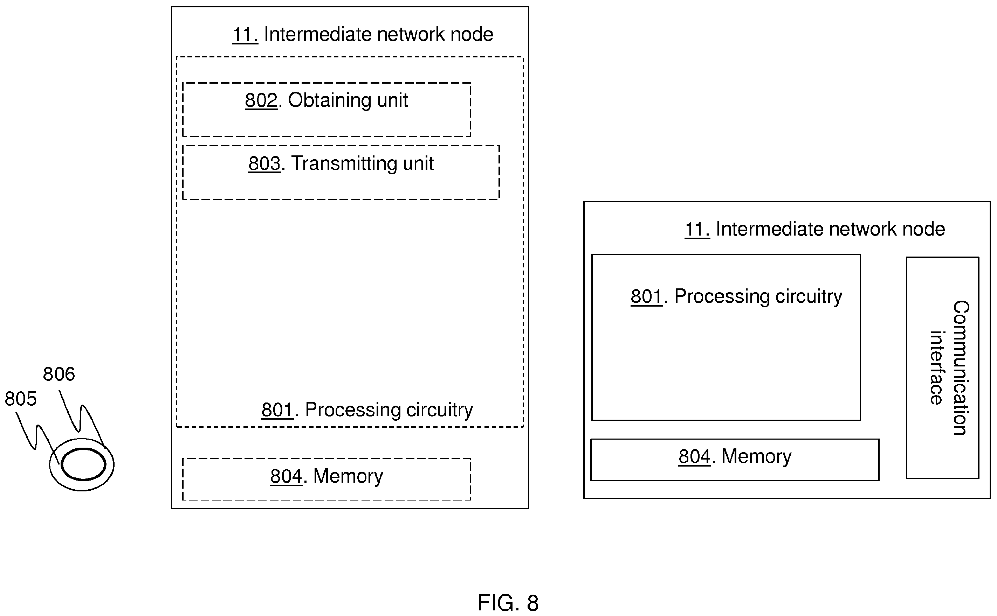

**Fig. 8** is a block diagram depicting the intermediate network node in two embodiments configured to operate in the communication network 1, wherein the communication network 1 comprises the requesting node 10 and the executing network node 12 comprising the computational graph model. The intermediate network node 11 may be for handling, e.g. providing responses such as analyzing or providing insights, operations of the communication network 1. This may be running somewhere in a cloud and the intermediate network node 11 may comprise **processing circuitry 801** e.g. one or more processors, configured to perform the methods herein.

The intermediate network node 11 is configured with the imitation model, wherein the imitation model is a limited version of the computational graph model, and wherein the imitation model is a model requiring less computational resources to converge when compared to the computational graph model. The imitation model may comprise one or more of following compared to the computational graph model: at least one input parameter less than the computational graph model; at least one output parameter less than the computational graph model; one or more functions of less computational complexity; and at least one less internal vertex or node of the computational graph model and/or at least one less edge of the computational graph model. The imitation model may have same amount of inputs (and outputs) as the computational graph model but may be simpler. For instance, in case of a feed-forward convolutional network, this would mean that there a smaller number of convolutional/maxpool layers. In case of a decision tree, this could mean smaller depth.

The intermediate network node 11 may comprise **an obtaining unit 802,** e.g. a receiver, transceiver or retrieving module. The intermediate network node 11, the processing circuitry 801, and/or the obtaining unit 802 may be configured to build the imitation model based on received one or more input parameters from the requesting node 10. The intermediate network node 11, the processing circuitry 801, and/or the obtaining unit 802 may be configured to build the imitation model by removing one or more parts of the imitation model that have not been used within a set interval and/or building the imitation model from scratch, and testing against one or more parent models, which contains the ground truth. There is also the ensemble-learning wherein the computational graph model is an ensemble of imitations models of one or more intermediate network nodes. The intermediate network node 11, the processing circuitry 801, and/or the obtaining unit 802 may be configured to obtain the imitation model from the computational graph model, e.g. receive from the executing network node 12 or another network node.

The intermediate network node 11, the processing circuitry 801, and/or the obtaining unit 802 may be configured to receive the request from the requesting node 10, wherein the request comprises one or more input parameters. The intermediate network node 11 may comprise **a transmitting unit 803,** e.g. a transmitter, transceiver or providing module. The intermediate network node 11, the processing circuitry 801, and/or the transmitting unit 803 may be configured to determine whether to respond to the request or to forward the one or more parameters towards the executing network node 12 by comparing the one or more input parameters to one or more needed input parameters of the imitation model and/or based on one or more output parameters of the imitation model,e.g. based on a probability of the sample belonging to a certain class is too low. The one or more parameters may be forwarded to a second intermediate node comprising a second imitation model being a version of the computational graph model requiring less computational resources to converge when compared to the computational graph model but more computational resources than the imitation model.

The computational graph model may be a neural network and/or a decision tree, and/or the intermediate network node may be configured to operate between the requesting node and the executing network node.

The intermediate network node 11 further comprises **a memory 804.** The memory comprises one or more units to be used to store data on, such as models, input parameters, output parameters, insights, data, processes to process the data, set of distributions, applications to perform the methods disclosed herein when being executed, and similar.

The methods according to the embodiments described herein for the intermediate network node are respectively implemented by means of e.g. **a computer program product 805** or a computer program, comprising instructions, i.e., software code portions, which, when executed on at least one processor, cause the at least one processor to carry out the actions described herein, as performed by the intermediate network node 11. The computer program 805 may be stored on **a computer-readable storage medium 806,** e.g. a disc or similar. The computer-readable storage medium 806, having stored thereon the computer program product, may comprise the instructions which, when executed on at least one processor, cause the at least one processor to carry out the actions described herein, as performed by the intermediate network node 11. In some embodiments, the computer-readable storage medium may be a non-transitory computer-readable storage medium. The intermediate network node 11 may comprise a communication interface comprising a transceiver, a receiver, a transmitter, and/or one or more antennas.

As will be readily understood by those familiar with communications design, that functions means, units, or modules may be implemented using digital logic and/or one or more microcontrollers, microprocessors, or other digital hardware. In some embodiments, several or all of the various functions may be implemented together, such as in a single application-specific integrated circuit (ASIC), or in two or more separate devices with appropriate hardware and/or software interfaces between them. Several of the functions may be implemented on a processor shared with other functional components of an intermediate network node, for example.

Alternatively, several of the functional elements of the processing circuitry discussed may be provided through the use of dedicated hardware, while others are provided with hardware for executing software, in association with the appropriate software or firmware. Thus, the term "processor" or "controller" as used herein does not exclusively refer to hardware capable of executing software and may implicitly include, without limitation, digital signal processor (DSP) hardware, read-only memory (ROM) for storing software, random-access memory for storing software and/or program or application data, and non-volatile memory. Other hardware, conventional and/or custom, may also be included. Designers of radio network nodes will appreciate the cost, performance, and maintenance trade-offs inherent in these design choices.

In some embodiments a non-limiting term "UE" is used. The UE herein may be any type of UE capable of communicating with network node or another UE over radio signals. The UE may also be a radio communication device, target device, device to device (D2D) UE, machine type UE or UE capable of machine to machine communication (M2M), Internet of things (IoT) operable device, a sensor equipped with UE, iPad, Tablet, mobile terminals, smart phone, laptop embedded equipped (LEE), laptop mounted equipment (LME), USB dongles, Customer Premises Equipment (CPE) etc.

Also in some embodiments generic terminology "network node", is used. It may be any kind of network node which may comprise of a *core network node,* e.g., NOC node, Mobility Managing Entity (MME), Operation and Maintenance (O&M) node, Self-Organizing Network (SON) node, a coordinating node, controlling node, Minimizing Drive Test (MDT) node, etc.), or an *external node* (e.g., 3^{rd} party node, a node external to the current network), or even a *radio network node* such as base station, radio base station, base transceiver station, base station controller, network controller, evolved Node B (eNB), Node B, multi-RAT base station, Multi-cell/multicast Coordination Entity (MCE), relay node, access point, radio access point, Remote Radio Unit (RRU) Remote Radio Head (RRH), etc.

The term "radio node" used herein may be used to denote the wireless device or the radio network node.

The term "signaling" used herein may comprise any of: high-layer signaling, e.g., via Radio Resource Control (RRC), lower-layer signaling, e.g., via a physical control channel or a broadcast channel, or a combination thereof. The signaling may be implicit or explicit. The signaling may further be unicast, multicast or broadcast. The signaling may also be directly to another node or via a third node.

The embodiments described herein may apply to any RAT or their evolution, e.g., LTE Frequency Duplex Division (FDD), LTE Time Duplex Division (TDD), LTE with frame structure 3 or unlicensed operation, UTRA, GSM, WiFi, short-range communication RAT, narrow band RAT, RAT for 5G, etc.

It will be appreciated that the foregoing description and the accompanying drawings represent non-limiting examples of the methods and apparatus taught herein. As such, the apparatus and techniques taught herein are not limited by the foregoing description and accompanying drawings. Instead, the embodiments herein are limited only by the following claims and their legal equivalents.

## Claims

1. An intermediate network node (11) configured to operate in a communication network (1), wherein the communication network (1) comprises a requesting node (10) and an executing network node (12) comprising a computational graph model; wherein the intermediate network node (11) is configured with an imitation model, wherein the imitation model is a limited version of the computational graph model, and wherein the imitation model is a model requiring less computational resources to converge when compared to the computational graph model, wherein the intermediate network node (11) is configured to build the imitation model based on received one or more input parameters from the requesting node (10), the intermediate network node (11) further being configured to:
- intercept a request from the requesting node (10), the request being for execution of the computational graph model,
- run the imitation model using input from the requesting node (10) and check confidence of an output,
- when the confidence is higher than a threshold, transmit a response to the requesting node (10), and
- when the confidence is lower than a threshold, relay the request to the executing network node (12).

2. The intermediate network node (11) according to claim 1, wherein the imitation model comprises one or more of following compared to the computational graph model: at least one input parameter less than the computational graph model; at least one output parameter less than the computational graph model; and at least one less internal vertex or node of the computational graph model and/or at least one less edge of the computational graph model.

3. The intermediate network node (11) according to any of the claims 1-3, wherein the intermediate network node (11) is configured to obtain the imitation model from the computational graph model.

4. The intermediate network node (11) according to any of the claims 1-4, wherein the computational graph model is a neural network and/or a decision tree.

5. The intermediate network node (11) according to any of the claims 1-5, wherein the intermediate network node (11) is configured to operate between the requesting node (10) and the executing network node (12).

6. A method performed by an intermediate network node (11) for operating in a communication network (1), wherein the communication network (1) comprises a requesting node (10) and an executing network node (12) comprising a computational graph model, the method comprising
- obtaining (601) an imitation model, wherein the imitation model is a limited version of the computational graph model, and wherein the imitation model is a model requiring less computational resources to converge when compared to the computational graph model, wherein the imitation model is built based on received one or more input parameters from the requesting node (10),
- intercepting a request from the requesting node (10), the request being for execution of the computational graph model,
- running the imitation model using input from the requesting node (10) and checking confidence of an output,
- when the confidence is higher than a threshold, transmitting a response to the requesting node (10), and
- when the confidence is lower than a threshold, relaying the request to the executing network node (12).

7. The method according to claim 6, wherein the imitation model comprises one or more of following compared to the computational graph model: at least one input parameter less than the computational graph model; at least one output parameter less than the computational graph model; and at least one less internal vertex or node of the computational graph model and/or at least one less edge of the computational graph model.

8. The method according to any of the claims 6-7, wherein obtaining the imitation model comprises obtaining the imitation model from the computational graph model.

9. The method according to any of the claims 6-8, wherein the computational graph model is a neural network and/or a decision tree.

10. The method according to any of the claims 6-9, wherein the intermediate network node (11) is configured to operate between the requesting node (10) and the executing network node (12).

11. A computer program product (805) comprising instructions, which, when executed on at least one processor, cause the at least one processor to carry out a method according to any of the claims 6-10, as performed by the intermediate network node (11).

12. A computer-readable storage medium (806), having stored thereon a computer program product comprising instructions which, when executed on at least one processor, cause the at least one processor to carry out a method according to any of the claims 6-10, as performed by the intermediate network node (11).

## Patentansprüche

1. Zwischennetzwerkknoten (11), der zum Betrieb in einem Kommunikationsnetzwerk (1) konfiguriert ist, wobei das Kommunikationsnetzwerk (1) einen anfordernden Knoten (10) und einen ausführenden Netzwerkknoten (12) umfasst, welcher ein Rechengraphmodell umfasst; wobei der Zwischennetzwerkknoten (11) mit einem Imitationsmodell konfiguriert ist, wobei das Imitationsmodell eine eingeschränkte Version des Rechengraphmodells ist und wobei das Imitationsmodell ein Modell ist, das im Vergleich zum Rechengraphmodell weniger Rechenressourcen benötigt, um zu konvergieren, wobei der Zwischennetzwerkknoten (11) konfiguriert ist, das Imitationsmodell auf Basis eines oder mehrerer empfangener Eingabeparameter vom anfordernden Knoten (10) zu erstellen, wobei der Zwischennetzwerkknoten (11) ferner dazu konfiguriert ist:
- Abfangen einer Anforderung vom anfordernden Knoten (10), wobei die Anforderung die Ausführung des Rechengraphmodells betrifft,
- Ausführen des Imitationsmodells unter Verwendung einer Eingabe vom anfordernden Knoten (10) und Prüfen der Konfidenz einer Ausgabe,
- wenn die Konfidenz höher als ein Schwellenwert ist, Übertragen einer Antwort an den anfordernden Knoten (10), und
- wenn die Konfidenz niedriger als ein Schwellenwert ist, Weiterleiten der Anforderung an den ausführenden Netzwerkknoten (12).

2. Zwischennetzwerkknoten (11) nach Anspruch 1, wobei das Imitationsmodell im Vergleich zum Rechengraphmodell eines oder mehrere des Folgenden umfasst: mindestens einen Eingabeparameter weniger als das Rechengraphmodell; mindestens einen Ausgabeparameter weniger als das Rechengraphmodell; und mindestens einen inneren Scheitelpunkt oder Knoten des Rechengraphmodells weniger und/oder mindestens eine Kante weniger als das Rechengraphmodell.

3. Zwischennetzwerkknoten (11) nach einem der Ansprüche 1 bis 3, wobei der Zwischennetzwerkknoten (11) konfiguriert ist, das Imitationsmodell anhand des Rechengraphmodells zu erhalten.

4. Zwischennetzwerkknoten (11) nach einem der Ansprüche 1 bis 4, wobei das Rechengraphmodell ein neuronales Netz und/oder ein Entscheidungsbaum ist

5. Zwischennetzwerkknoten (11) nach einem der Ansprüche 1 bis 5, wobei der Zwischennetzwerkknoten (11) zum Betrieb zwischen dem anfordernden Knoten (10) und dem ausführenden Netzwerkknoten (12) konfiguriert ist.

6. Verfahren, das von einem Zwischennetzwerkknoten (11) zum Betrieb in einem Kommunikationsnetzwerk (1) durchgeführt wird, wobei das Kommunikationsnetzwerk (1) einen anfordernden Knoten (10) und einen ausführenden Netzwerkknoten (12) mit einem Rechengraphmodell umfasst, wobei das Verfahren umfasst:
- Erhalten (601) eines Imitationsmodells, wobei das Imitationsmodell eine eingeschränkte Version des Rechengraphmodells ist und wobei das Imitationsmodell ein Modell ist, das im Vergleich zu dem Rechengraphmodell weniger Rechenressourcen zur Konvergenz benötigt, wobei das Imitationsmodell auf Basis eines oder mehrerer empfangener Eingabeparameter vom anfordernden Knoten (10) erstellt wird,
- Abfangen einer Anforderung vom anfordernden Knoten (10), wobei die Anforderung die Ausführung des Rechengraphmodells betrifft,
- Ausführen des Imitationsmodells unter Verwendung einer Eingabe vom anfordernden Knoten (10) und Prüfen der Konfidenz einer Ausgabe,
- wenn die Konfidenz höher als ein Schwellenwert ist, Übertragen einer Antwort an den anfordernden Knoten (10), und
- wenn die Konfidenz niedriger als ein Schwellenwert ist, Weiterleiten der Anforderung an den ausführenden Netzwerkknoten (12).

7. Verfahren nach Anspruch 6, wobei das Imitationsmodell im Vergleich zum Rechengraphmodell eines oder mehrere des Folgenden umfasst: mindestens einen Eingabeparameter weniger als das Rechengraphmodell; mindestens einen Ausgabeparameter weniger als das Rechengraphmodell; und mindestens einen inneren Scheitelpunkt oder Knoten des Rechengraphmodells weniger und/oder mindestens eine Kante weniger als das Rechengraphmodell.

8. Verfahren nach einem der Ansprüche 6 bis 7, wobei das Erhalten des Imitationsmodells das Erhalten des Imitationsmodells aus dem Rechengraphmodell umfasst.

9. Verfahren nach einem der Ansprüche 6 bis 8, wobei das Rechengraphmodell ein neuronales Netz und/oder ein Entscheidungsbaum ist

10. Verfahren nach einem der Ansprüche 6 bis 9, wobei der Zwischennetzwerkknoten (11) zum Betrieb zwischen dem anfordernden Knoten (10) und dem ausführenden Netzwerkknoten (12) konfiguriert ist.

11. Computerprogrammprodukt (805), das Anweisungen umfasst, die bei Ausführung auf mindestens einem Prozessor den mindestens einen Prozessor dazu veranlassen, ein Verfahren nach einem der Ansprüche 6 bis 10 auszuführen, wie es von dem Zwischennetzwerkknoten (11) durchgeführt wird.

12. Computerlesbares Speichermedium (806), auf dem ein Computerprogrammprodukt gespeichert ist, das Anweisungen umfasst, die bei Ausführung auf mindestens einem Prozessor den mindestens einen Prozessor dazu veranlassen, ein Verfahren nach einem der Ansprüche 6 bis 10 auszuführen, wie es von dem Zwischennetzwerkknoten (11) durchgeführt wird.

## Revendications

1. Nœud de réseau intermédiaire (11) configuré pour fonctionner dans un réseau de communication (1), dans lequel le réseau de communication (1) comprend un nœud de demande (10) et un nœud de réseau d'exécution (12) comprenant un modèle de graphe de calcul ; dans lequel le nœud de réseau intermédiaire (11) est configuré avec un modèle d'imitation, dans lequel le modèle d'imitation est une version limitée du modèle de graphe de calcul, et dans lequel modèle d'imitation est un modèle nécessitant moins de ressources de calcul pour converger par rapport au modèle de graphe de calcul, dans lequel le nœud de réseau intermédiaire (11) est configuré pour construire le modèle d'imitation à partir d'un ou plusieurs paramètres d'entrée reçus du nœud de demande (10), le nœud de réseau intermédiaire (11) étant en outre configuré pour :
- intercepter une demande provenant du nœud de demande (10), la demande étant pour l'exécution du modèle de graphe de calcul,
- exécuter le modèle d'imitation en utilisant l'entrée du nœud de demande (10) et vérifier la confiance d'une sortie,
- lorsque la confiance est supérieure à un seuil, transmettre une réponse au nœud de demande (10), et
- lorsque la confiance est inférieure à un seuil, relayer la demande au nœud de réseau d'exécution (12).

2. Nœud de réseau intermédiaire (11) selon la revendication 1, dans lequel le modèle d'imitation comprend un ou plusieurs des éléments suivants par rapport au modèle de graphe de calcul : au moins un paramètre d'entrée inférieur au modèle de graphe de calcul ; au moins un paramètre de sortie inférieur au modèle de graphe de calcul ; et au moins un sommet ou nœud interne de moins du modèle de graphe de calcul et/ou au moins une arête de moins du modèle de graphe de calcul.

3. Nœud de réseau intermédiaire (11) selon l'une quelconque des revendications 1 à 3, dans lequel le nœud de réseau intermédiaire (11) est configuré pour obtenir le modèle d'imitation à partir du modèle de graphe de calcul.

4. Nœud de réseau intermédiaire (11) selon l'une quelconque des revendications 1 à 4, dans lequel le modèle de graphe de calcul est un réseau neuronal et/ou un arbre de décision.

5. Nœud de réseau intermédiaire (11) selon l'une quelconque des revendications 1 à 5, dans lequel le nœud de réseau intermédiaire (11) est configuré pour fonctionner entre le nœud de demande (10) et le nœud de réseau d'exécution (12).

6. Procédé réalisé par un nœud de réseau intermédiaire (11) pour fonctionner dans un réseau de communication (1), dans lequel le réseau de communication (1) comprend un nœud de demande (10) et un nœud de réseau d'exécution (12) comprenant un modèle de graphe de calcul, le procédé comprenant
- l'obtention (601) d'un modèle d'imitation, dans lequel le modèle d'imitation est une version limitée du modèle de graphe de calcul, et dans lequel le modèle d'imitation est un modèle nécessitant moins de ressources de calcul pour converger par rapport au modèle de graphe de calcul, dans lequel le modèle d'imitation est construit sur la base d'un ou plusieurs paramètres d'entrée reçus du nœud de demande (10),
- l'interception d'une demande provenant du nœud de demande (10), la demande étant pour l'exécution du modèle de graphe de calcul,
- l'exécution du modèle d'imitation en utilisant l'entrée du nœud de demande (10) et la vérification de la confiance d'une sortie,
- lorsque la confiance est supérieure à un seuil, la transmission d'une réponse au nœud de demande (10), et
- lorsque la confiance est inférieure à un seuil, le relais de la demande au nœud de réseau d'exécution (12).

7. Procédé selon la revendication 6, dans lequel le modèle d'imitation comprend un ou plusieurs des éléments suivants par rapport au modèle de graphe de calcul : au moins un paramètre d'entrée inférieur au modèle de graphe de calcul ; au moins un paramètre de sortie inférieur au modèle de graphe de calcul ; et au moins un sommet ou nœud interne de moins du modèle de graphe de calcul et/ou au moins une arête de moins du modèle de graphe de calcul.

8. Procédé selon l'une quelconque des revendications 6 à 7, dans lequel l'obtention du modèle d'imitation comprend l'obtention du modèle d'imitation à partir du modèle de graphe de calcul.

9. Procédé selon l'une quelconque des revendications 6 à 8, dans lequel le modèle de graphe de calcul est un réseau neuronal et/ou un arbre de décision.

10. Procédé selon l'une quelconque des revendications 6 à 9, dans lequel le nœud de réseau intermédiaire (11) est configuré pour fonctionner entre le nœud de demande (10) et le nœud de réseau d'exécution (12).

11. Produit de programme informatique (805) comprenant des instructions qui, lorsqu'elles sont exécutées sur au moins un processeur, amènent l'au moins un processeur à mettre en œuvre un procédé selon l'une quelconque des revendications 6 à 10, tel qu'il est réalisé par le nœud de réseau intermédiaire (11).

12. Support de stockage lisible par ordinateur (806), sur lequel est stocké un produit de programme informatique comprenant des instructions qui, lorsqu'elles sont exécutées sur au moins un processeur, amènent l'au moins un processeur à mettre en œuvre un procédé selon l'une quelconque des revendications 6 à 10, tel qu'il est réalisé par le nœud de réseau intermédiaire (11).
